Europäisches Patentamt

European Patent Office

Office européen des brevets

(11) Veröffentlichungsnummer: **0 416 154 A1**

## (12) EUROPÄISCHE PATENTANMELDUNG

(21) Anmeldenummer: 89116559.9

(22) Anmeldetag: 07.09.89

(51) Int. Cl.5: **H03K 17/687**, H02M 3/07

(43) Veröffentlichungstag der Anmeldung:
**13.03.91 Patentblatt 91/11**

(84) Benannte Vertragsstaaten:
**AT BE CH DE ES FR GB GR IT LI LU NL SE**

(71) Anmelder: **Siemens Aktiengesellschaft**
**Wittelsbacherplatz 2**
**W-8000 München 2(DE)**

(72) Erfinder: **Schwendt, Ralf, Dipl.-Ing.**
**Sengelsweg 59**
**W-4 Düsseldorf 31(DE)**

(54) **Schaltungsanordnung zur Erhöhung der Ausgangsspannung einer elektronischen Schaltstufe.**

(57) Schaltungsanordnung mit einem ersten elektronischen Umschalter (6-9), dessen Ausgang während einer ersten Schaltphase auf ein erstes Betriebspotential (1) und während einer zweiten Schaltphase auf ein zweites Betriebspotential (2) aufgeschaltet ist, mit einen zweiten elektronischen Umschalter (10-13), dessen Ausgang während der ersten Schaltphase auf das erste Betriebspotential (1) und während der zweiten Schaltphase auf einen Knotenpunkt aufgeschaltet ist, mit einer Diode (14), die in Durchlaßrichtung zwischen das zweite Betriebspotential (2) und den Knotenpunkt geschaltet ist, und mit einem Kondensator (5), der zwischen dem Ausgang des ersten elektronischen Umschalters und den Knotenpunkt geschaltet ist.

# SCHALTUNGSANORDNUNG ZUR ERHÖHUNG DER AUSGANGSSPANNUNG EINER ELEKTRONISCHEN SCHALTSTUFE

Die Erfindung betrifft eine Schaltungsanordnung zur Erhöhung der Ausgangsspannung einer elektronischen Schaltstufe.

Bei unipolaren Schaltungstechniken werden häufig statisch getaktete Schaltstufen, insbesondere sogenannte Transfertransistoren, benutzt, um Signale zu definierten Zeitpunkten zu schalten. Die Amplitude eines solchen Taktsignals ist im allgemeinen betragsmäßig gleich der Versorgungsspannung, wodurch am Ausgang des Transfertransistors maximal die Spannungsdifferenz zwischen der Versorgungsspannung und der Einsatzspannung des schaltenden Transistors als Spannungshub zur Verfügung steht. In vielen Anwendungsfällen ist es jedoch wünschenswert, das Signal mit einem Spannungshub gleich der Versorgungsspannung zu schalten. Hierbei bedient man sich häufig sogenannter Bootstrap-Ausgangsstufen, die die Spannung des Transfertransistors betragsmäßig auf einen Wert größer oder gleich der Versorgungsspannung erhöhen können. Derartige Bootstrap-Ausgangsstufen sind beispielsweise aus H. Weiß, K. Horninger, Integrierte MOS-Schaltungen, 1. Auflage 1982, Seite 169 ff, bekannt.

Bei bevorzugten Ausführungsformen bekannter Bootstrap-Ausgangsstufen wird während einer ersten Schaltphase des zugeführten Taktes über einen elektronischen Schalter eine Kapazität auf die Versorgungsspannung minus der Einsatzspannung des elektronischen Schalters vorgeladen (Vorladephase). Mit einem nichtüberlappenden, weiteren Takt wird zeitgleich mit dem Abschalten des elektronischen Schalters das Bezugspotential des Kondensators von einem ersten Betriebspotential auf ein zweites Betriebspotential angehoben, wobei die Versorgungsspannung gleich dem zweiten Betriebspotential abzüglich dem zweiten Betriebspotential ist. Dadurch steht am Ausgang der Schaltung im günstigsten Fall der doppelte

Wert der Versorgungsspannung zur Verfügung. Es ist jedoch störend, daß während der Vorladephase die gesamte Ladespannung am Ausgang anliegt, wodurch nachfolgende Schaltungen bereits vor dem gewünschten Zeitpunkt angesteuert werden und insofern unerwünschte Ströme fließen.

Aufgabe der Erfindung ist es daher, eine Schaltungsanordnung anzugeben, bei der keine Vorladephase notwendig ist.

Diese Aufgabe wird bei einer Schaltungsanordnung der eingangs geannnten Art durch die kennzeichnenden Merkmale des Patentanspruches 1 gelöst. Ausgestaltungen des Erfindungsgedankens sind in Unteransprüchen gekennzeichnet.

Vorteile der Erfindung sind, daß der Kondensator eine geringere Kapazität aufweist als bei der bekannten Anordnung, da der Ausgang während der Ladephase abgekoppelt ist und daß (aufgrund der kleineren Kapazität) die am Ausgang anliegenden Impulse steilere Flanken aufweisen. Darüber hinaus sind die geringe Leistungsaufnahme und der geringe schaltungstechnische Aufwand vorteilhaft.

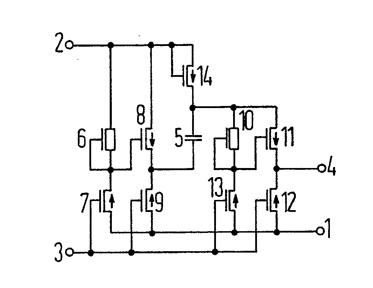

Die Erfindung wird nachfolgend anhand des in der einzigen FIG der Zeichnung dargestellten Ausführungsbeispiels näher erläutert.

Bei dem in der Zeichnung dargestellten Ausführungsbeispiel ist erfindungsgemäß ein Transistoren 6 bis 9 aufweisender erster elektronischer Umschalter, ein Transistoren 10 bis 13 aufweisender zweiter elektronischer Umschalter, eine Diode 14 und ein Kondensator 5 vorgesehen. Der Ausgang des ersten Umschalters, der während einer durch ein Taktsignal 3 vorgegebenen ersten Schaltphase auf ein negatives erstes Betriebspotential 1 und während einer durch das Taktsignal 3 vorgegebenen zweiten Schaltphase auf ein positives zweites Betriebspotential 2 aufgeschaltet ist, und ein Knotenpunkt, auf dem über die Diode 14 in Durchlaßrichtung das zweite Betriebspotential 2 gelegt ist, sind über den Kondensator 5 miteinander verbunden. Der Ausgang des zweiten Umschalters, an dem das Ausgangssignal 4 der gesamten Schaltungs anordnung anliegt, ist während der ersten Schaltphase auf das erste Betriebspotential 1 und während der zweiten Schaltphase auf den Knotenpunkt aufgeschaltet.

In Ausgestaltung der Erfindung weisen die beiden Umschalter jeweils eine Gegentaktstufe mit je zwei draingekoppelten Enhancement-MOS-Feldeffekttransistoren vom N-Kanal-Typ 8 und 9 bzw. 11 und 12 auf, wobei die Gateanschlüsse der Transistoren 9 und 12, deren Sourceanschlüsse an dem ersten Betriebspotential 1 angeschlossen sind, direkt und die Gateanschlüsse der Transistoren 8 und 11, deren Sourceanschlüsse an dem zweiten Betriebspotential 2 angeschlossen sind, über jeweils eine Inverterstufe mit dem Taktsignal 3 beaufschlagt sind. Bei den Inverterstufen ist jeweils ein Enhancement-MOS-Feldeffekttransistor 7 bzw. 13 vom N-Kanal-Typ vorgesehen, dessen Sourceanschluß an das erste Betriebspotential 1 angeschlossen ist und dessen Gateanschluß mit dem Taktsignal 3 beaufschlagt ist. Der Drainanschluß ist dabei jeweils zum einen mit dem Gateanschluß des Transistors 8 bzw. 11 verbunden und zum anderen über einen die Erfindung ausgestaltend durch Verbinden von Gate-und Drainanschluß als Stromquelle betriebenen Depletion-MOS-Feldeffekttransistor 6 bzw. 10 an das zweite Betriebspotential 2 angeschlossen. Als Ausgänge der Inverterstufen sind die gekoppelten Drainanschlüsse der Transistoren 8 und 9 bzw. 11 und 12 vorgesehen. Die Diode 14 schließlich wird im vorliegenden Ausführungsbeispiel durch einen Transistor vom Kanal-Typ gebildet, bei dem Source- und Gateanschluß miteinander verbunden sind.

Der Spannungshub des Ausgangssignals 4 ist damit gleich dem doppelten Wert der Versorgungsspannung minus der Einsatzspannung der Transistoren 8, 9, 11 und der Diode 14. Während der Ladephase des Kondensators 5 ist der Ausgang der Schaltungsanordnung durch den Transistor 11 entkoppelt, wodurch die Last am Ausgang keinen Einfluß auf die Ladung des Kondensators 5 hat. Dieser kann deshalb eine geringere Kapazität aufweisen, wodurch ein geringerer Ladestrom und ein schnelleres Aufladen gewährleistet wird.

Darüber hinaus wird die Leistungsaufnahme weiter gesenkt, in dem Querströme durch die relativ hochohmigen Depletion-MOS-Transis toren 6 und 10 begrenzt werden. Ferner wird durch eine Signalverzögerung, hervorgerufen durch die Transistoren 6 bis 9, verhindert, daß zum Zeitpunkt der Abschaltung des Kondensators 5 über den geöffneten Strompfad mit den Transistoren 10 und 13 entladen wird, wodurch die Leistungsaufnahme ebenfalls gesenkt wird. Neben der geringeren Leistungsaufnahme sind aber auch insbesondere steilere Anstiegs- und Abfallflanken und ein geringerer Platzbedarf als weitere Vorteile zu nennen, was die Integrierbarkeit einer solchen Schaltungsanordnung erleichtert.

## Ansprüche

1. Schaltungsanordnung **gekennzeichnet durch** einen ersten elektronischen Umschalter (6...9), dessen Ausgang während einer ersten Schaltphase auf ein erstes Betriebspotential (1) und während einer zweiten Schaltphase auf ein zweites Betriebspotential (2) aufgeschaltet ist, durch einen zweiten elektronischen Umschalter (10...12), dessen Ausgang während der ersten Schaltphase auf das erste Betriebspotential (1) und während der zweiten Schaltphase auf einen Knotenpunkt aufgeschaltet ist, durch eine Diode (14), die in Durchlaßrichtung zwischen das zweite Betriebspotential (2) und den Knotenpunkt geschaltet ist, und durch einen Kondensator (5), der zwischen dem Ausgang des ersten elektronischen Umschalters (6...9) und den Knotenpunkt geschaltet ist.

2. Schaltungsanordnung nach Anspruch 1, **dadurch gekennzeichnet,** daß als elektronischer Umschalter (6...9, 10...12) eine zwei Transistoren (8, 9; 11, 12) aufweisende Gegentaktstufe vorgesehen ist, wobei einem der beiden Transistoren (8, 11) eine Inverterstufe (6, 7; 10, 13) vorgeschaltet ist.

3. Schaltungsanordnung nach Anspruch 2, **dadurch gekennzeichnet,** daß als Inverterstufe (6, 7; 10, 13) ein dritter Transistor (7; 13) vorgesehen ist, in dessen Lastkreis ein als Stromquelle betriebener vierter Transistor (6; 10) geschaltet ist.

4. Schaltungsanordnung nach Anspruch 2 oder 3, **dadurch gekennzeichnet,** daß alle Transistoren (6...14) MOS-Feldeffekttransistoren sind.

5. Schaltungsanordnung nach Anspruch 4, **dadurch gekennzeichnet,** daß als vierter Transistor (6; 10) ein Depletion-MOS-Feldeffekttransistor vorgesehen ist.

| | Europäisches Patentamt | EUROPÄISCHER RECHERCHENBERICHT | Nummer der Anmeldung |
|---|---|---|---|
| | | | EP 89 11 6559 |

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | EP-A-0 297 844 (MINNESOTA MINING AND MANUFACTURING CO.) * Seite 9, Zeile 21 - Seite 10, Zeile 44; Figuren 4,5 * | 1,2,4 | H 03 K 17/687 H 02 M 3/07 |
| Y | --- | 3,5 | |
| Y | IBM TECHNICAL DISCLOSURE BULLETIN, Band 18, Nr. 3, August 1975, Seiten 910-911, New York, US; M.E. HOMAN: "FET depletion load push-pull logical circuit" * Seite 910, Zeile 11 - Seite 911, Zeile 10; Figur * ----- | 3,5 | |

| | RECHERCHIERTE SACHGEBIETE (Int. Cl.5) |
|---|---|
| | H 03 K H 02 M |

Der vorliegende Recherchenbericht wurde für alle Patentansprüche erstellt

| Recherchenort | Abschlußdatum der Recherche | Prüfer |
|---|---|---|
| DEN HAAG | 03-05-1990 | CANTARELLI R.J.H. |